# EUROPEAN PATENT APPLICATION

(11) **EP 2 620 641 A2**
(43) Date of publication of application: **31.07.2013**
(21) Application number: 12008489.2
(22) Date of filing: 20.12.2012
(51) Int. Cl.: F03D 11/00, G01R 31/34

(54) **Method and apparatus for testing in field wind turbines**

(30) Priority: 29.12.2011 ES 201101374
(71) Applicant: Gamesa Innovation & Technology, S.L., 31621 Sarriguren (ES)
(72) Inventor: Linares Fano, Miguel, 31486 Sarriguren (Navarra) (ES); Rodriguez Vazquez, Miguel, 31486 Sarriguren (Navarra) (ES); Marrero Sosa, Juan Alberto, 31486 Sarriguren (Navarra) (ES)

(57) **Abstract**

Method and apparatus for testing in field wind turbines. The method comprises connecting the wind turbine (11) to an electrical grid (15), both configured for a given nominal voltage and nominal frequency of 50 or 60 Hz via a conversion device (13) that allows adaptation of the characteristics of the electrical grid (15) on the side of the wind turbine conversion device (11) to the conditions required by the test to be performed to the wind turbine (11), including the adaptation of the rated frequency of the electric grid (15) to the rated frequency of the wind turbine (11), when are different, so can make identical tests to wind turbines(11) configured for different nominal frequencies in the same location. The invention also relates to said conversion device (13).

## Description

### FIELD OF THE INVENTION

This invention relates to testing methods and apparatus of wind turbines and, more particular, to testing methods and apparatus to validate new models of wind turbines.

### BACKGROUND OF THE INVENTION

The emerging wind energy market is constantly generating new wind turbine models and references increasingly powerful, competitive and efficient. The increasing number of references is largely due to the off-shore market take off, the constant emergence of network connection requirements and the demand for flexibility in new markets and on-shore wind parks,

The validation and certification requirements are more and more numerous and demanding so wind turbines are becoming larger and more powerful making these processes more expensive and complex. Wind turbine manufacturers,have been constantly refining and improving verification and validation processes in order to minimize technical uncertainties, cost and availability of the product term for the market.

Nowadays the validation and certification of each new wind turbine model requires the manufacture, installation and commissioning of real prototypes for each grid frequency (50 or 60 Hz).

To comply with these requirements, test benches have been developed for testing wind turbines and wind turbine components in, mainly, laboratories and manufacturing plants for performing a variety of tests including tests for evaluating the adaptation of the wind turbine to the grid requirements (ranges V/f, voltage dips, harmonic level control, etc.).

One drawback of the known methods and apparatus for testing new models of wind turbines is the need of specific test benches for each grid frequency (50 or 60 Hz.). Another drawback is their lack of flexibility for being used in different sites.

### SUMMARY OF THE INVENTION

It is an object of the present invention to provide methods and apparatus for testing in field wind turbines.

It is another object of the present invention to provide methods and apparatus for testing in field new prototypes of wind turbines for certification and validation purposes.

In one aspect this and another objects are met by a method for testing in field a wind turbine, the wind turbine being configured for providing power at a given rated voltage and at a rated frequency of 50 or 60 Hz; the method comprising connecting the wind turbine to an electric grid of a given rated voltage and of a rated frequency of 50 or 60 Hz through a conversion device that allows the adaptation of the features of the electric grid at the wind turbine side of said conversion device to the conditions requested by the tests to be performed to the wind turbine;said adaptation including the adaptation of the rated frequency of the electric grid to the rated frequency of the wind turbine, when they are different, so that identical tests to wind turbines configured for different rated frequencies can be performed in the same site.

Advantageously, the rated voltages of the electric grid and the wind turbine are comprised between 10-66 kv, i.e. a wind farm medium voltage.

In one embodiment of the method, said adaptation further comprises stabilizing the voltage and the frequency of the electric grid at the wind turbine side of the conversion device. Hereby it is provided a method for performing steady state tests for, among others, validation and/or certification purposes.

In one embodiment of the method, said adaptation further comprises generating voltage and/or frequency fluctuations in predetermined time periods at the wind turbine side of the conversion device.Hereby it is provided a method for performing quasi steady state tests for, among others, validation purposes.

In one embodiment of said method, said adaptation further comprises generating voltage and/or frequency transients in predetermined time periods at the wind turbine side of the conversion device,Hereby it is provided a method for performing transient steady state tests for, among others, grid code compliance purposes.

In another aspect, the above-mentioned objects are met by a method for testing in field a wind turbine, the wind turbine being configured for providing power at a given rated voltage and at a rated frequency of 50 or 60 Hz;the method comprising connecting the wind turbine to an electric grid of a given rated voltage and of a rated frequency of 50 or 60 Hz through a conversion device that allows the adaptation of the features of the electric grid at the wind turbine side of said conversion device to the conditions requested by the tests to be performed to the wind turbine, and through a voltage dip generator at the wind side of said conversion device;said adaptation including the adaptation of the rated frequency of the electric grid to the rated frequency of the wind turbine, when they are different, so that identical tests to wind turbines configured for different rated frequencies can be performed in the same site;said voltage dip generator allowing the generation of grid voltage transients in predetermined time periods at the wind turbine side of said conversion device.

In embodiments of the method, said adaptation further comprises stabilizing the voltage and the frequency of the electric grid at the wind turbine side of the conversion deviceor generating voltage and/or frequency fluctuations in predetermined time periods at the wind turbine side of the conversion device for the same purposes above-mentioned.

In a third aspect, the above-mentioned objects are met by a conversion device connectable between one or more wind turbines installed in a site and an electric grid of a given rated voltage and of a rated frequency of 50 or 60 Hz for performing tests in field to the wind turbines;said wind turbines being configured for providing power at a given rated voltage and at a rated frequency of 50 or 60 Hz; the conversion device comprising one or more grid side transformers, one or more converter units and one or more wind turbine side transformers;each converter unit comprising a grid side harmonic filter a back-to-back converter and a wind turbine side harmonic filter;the conversion device comprising control means allowing the adaptation of the features of the electric grid at the wind turbine side of the conversion device to the conditions requested by said tests; said adaptation including the adaptation of the rated frequency of the electric grid to the rated frequency of the wind turbine, when they are different, so that identical tests to wind turbines configured for different rated frequencies can be performed in the same site.

The conversion device further comprises, as connection means, a wind turbine switchgear, a power grid switchgear and a by-pass switch for facilitating its operation.

In an embodiment the conversion device is configured in transportable modules, particularly, in three modules, the first module comprising the grid side switchgear and the grid side transformers, the second module comprising the converter units and the third module comprising the wind turbine side switchgear and the wind turbine side transformers.

Other desirable features and advantages of the invention will become apparent from the subsequent detailed description of the invention and the appended claims, in relation with the enclosed drawings.

### BRIEF DESCRIPTION OF THE DRAWINGS

Figure 1 shows schematically a conversion device connected to a power grid and to a wind turbine for performing tests in field to the wind turbine according to the present invention.
Figure 2a, 2b and 2c show schematically different connection states of the conversion device according to the present invention.
Figures 3a and 3d are schematic views of a connection of the conversion device according to the present invention to wind turbines placed at different positions in a wind farm branch.
Figures 4, 5 and 6 show three embodiments of the conversion device according to the present invention.
Figure 7 shows a modular embodiment of the conversion device according to the present invention.
Figure 8 is a diagram showing respectively the courses of the voltage and frequency at both sides of the conversion device when a test according to the present invention is performed.
Figures 9a and 9b are diagrams illustrating the references used for generating the desired voltage and frequency courses at the wind turbine side of the conversion device for performing a test according to the present invention.
Figure 10 shows schematically a combination of a conversion device and a voltage dip generator connected to a power grid and to a wind turbine for performing tests in field to the wind turbine according to the present invention.

### DETAILED DESCRIPTION OF THE INVENTION

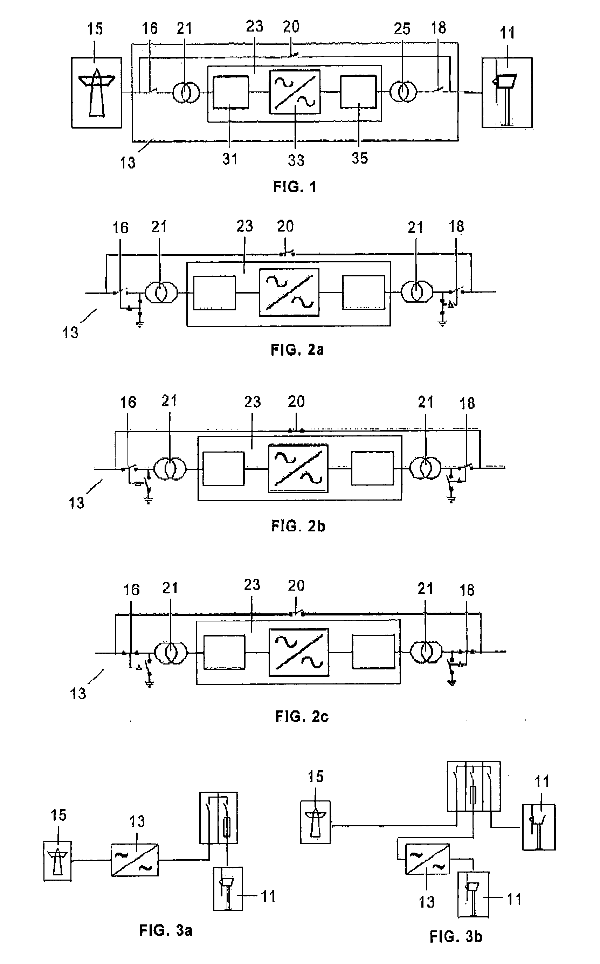

Figure 1 shows schematically the main components of a conversion device 13 according to this invention connected to a wind turbine 11 installed in a site and to a power grid 15, for example a medium voltage grid of a wind farm: a grid side transformer 21, a converter unit 23 comprising a grid side harmonic filter 31, a back-to-back converter 33, a wind turbine side harmonic filter 35, and a wind turbine side transformer 25.

The grid side transformer 21 reduces grid side voltage level to rated voltage of the grid side converter

The grid side harmonic filter 31 is a sinusoidal filter to reduce harmonic emission of the grid side converter,

The back-to-back converter 33 is an ac/dc/ac converter to decouple the electrical systems of the power grid 15 and the wind turbine 11 by means of a dc link.

The wind turbine side harmonic filter 35 is a sinusoidal filter to reduce harmonic emission of the wind turbine side converter.

The wind turbine side transformer 25 raises the rated voltage of the wind turbine side converter to the rated voltage of the wind turbine 11.

The connection means of the conversion device 13 with the wind turbine 11 and the power grid 11 are the wind turbine switchgear 18, the grid side switchgear 16 and a by-pass switch 20.

The main functions of the conversion device 13 are:
- acting as voltage source for the wind turbine 11, being the voltage and frequency at the wind turbine side of the conversion device the variables to be controlled by the control means of the conversion device 13 for performing tests to the wind turbine 11;
- evacuating to the power grid 15 all the active power generated by the wind turbine 11, and if needed, supplying power to the wind turbine for maintenance operations.

The connections state of the conversion device 13 with the wind turbine 11 and to the power grid 15 can be one of the following:
- Safety. In this connection state (see Figure 2a) the by-pass switch 20 is opened, the grid side switchgear 16 is grounded, the wind turbine side switchgear 18 is grounded and the converter unit 23 is stopped. Operations of the maintenance personnel inside the components of the conversion device 13 in this connection state are allowed.
- By-pass. In this connection state (see Figure 2b) the by-pass switch 20 is closed, the grid side switchgear 16 is opened, the wind turbine side switchgear 18 is opened and the converter unit 23 is stopped. In this state, the wind turbine can operate supplied directly by the grid. This connection state allows a direct connection between the wind turbine 11 and the power grid 15 when a failure is detected in the conversion device 13 without disconnection of the cabling. This connection state is only possible when grid frequency and voltage are compatible to wind turbine frequency and voltage range, i.e. when the conversion device 13 is used for performing tests when the rated frequency of the power grid 15 and the rated frequency of the wind turbine 11 is the same.
- Stop: In this connection state (see Figure 2c) the by-pass switch 20 is opened, the grid side switchgear 16 is closed, the wind turbine side switchgear 18 is closed and the converter unit 23 is stopped. In this state the converter unit 23 is ready to pass to a run state.
- Run: In this connection state (see Figure 2c) the by-pass switch 20 is opened, the grid side switchgear 16 is closed, the wind turbine side switchgear is 18 closed and the converter unit 23 is running in order to achieve the voltage and frequency references at the wind turbine side.

Figure 3a shows the connection of the conversion device 13 to the power grid 15 and to a wind turbine 11 placed in the last position of a branch of a wind farm and Figure 3b shows the connection of the conversion device 13 to the power grid 15 and to a wind turbine 11 placed in an intermediate position of a branch of a wind farm.

The particular implementation of the conversion device 13 will depend among other factors of the power and voltage levels of the wind turbine or wind turbines 11 to be connected to the conversion device 13.

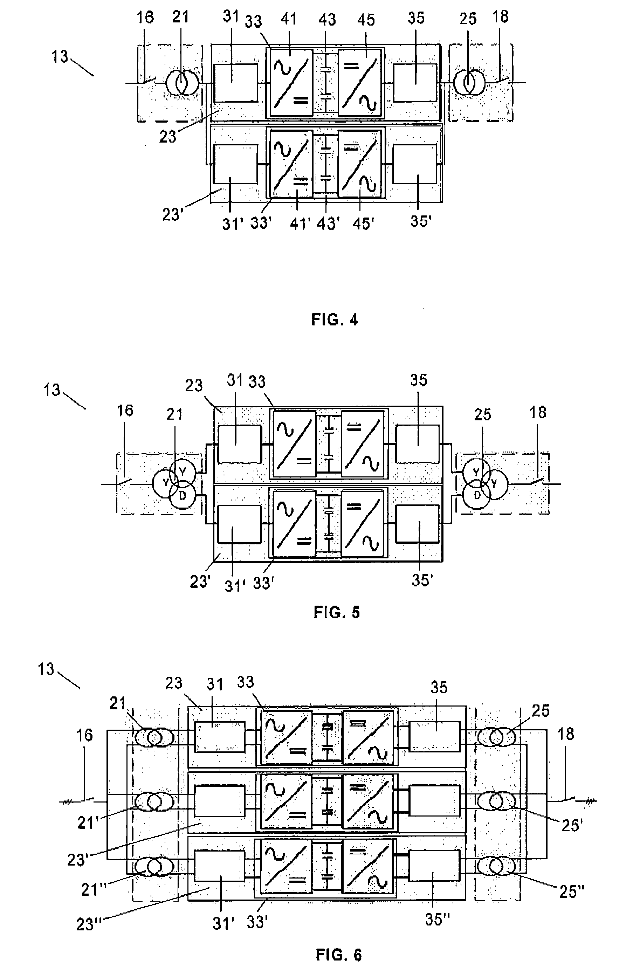

Figure 4 shows an implementation based on a multi-modular three-phase multilevel converter with several parallel connected three-phase converter unit's 23, 23' and two-winding three-phase transformers 21, 25.

In the three-phase converter units 23, the grid side converter 41, the DC link 43 and the wind turbine side converter 45 are shown

Figure 5 shows an implementation based on a double multilevel three-phase converter with groups of two converter units 23, 23' and phase-shifting transformers 21, 25.

Figure 6 shows an implementation based on a multilevel H-bridge converter with groups of three converter units 23, 23', 23" and open-windings three-phase grid side transformers 21, 21', 21" and three-phase wind turbine side transformers 25, 25', 25".

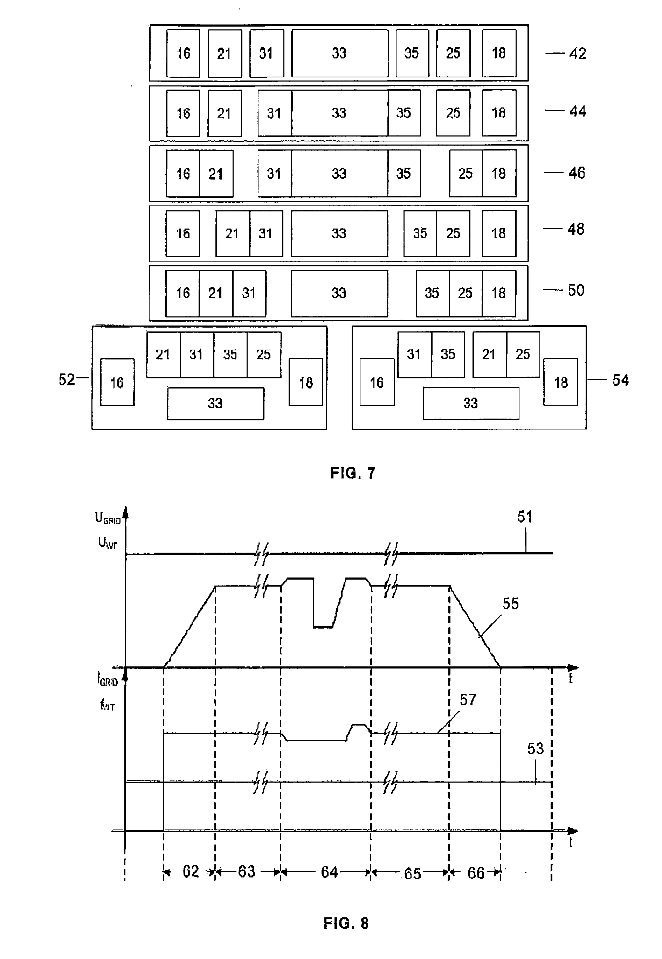

Figure 7 shows a modular embodiment of the conversion device 13 for facilitating its transportation and installation in field. Module 44 groups the grid side switch 16and the grid side transformer 21 (or grid side transformers 21, 21', 21"). Module 46 corresponds to the converter unit 23 (or converter units 23, 23', 23") and Module 48 groups the wind turbine switch 18 and the wind turbine side transformer 25 (or wind turbine side transformers 25, 25', 25").

The conversion device 13 can be arranged so that voltage and frequency at the wind turbine side followsa desired course for performing tests to the wind turbine as in the example illustrated in Figure 8. Lines 51 and 53 show the temporal evolution of the voltage Ugrid and frequency fgrid at the power grid side and lines 55, 57 show the desired simultaneous evolution of the voltage Uwt and frequency fwt at the wind turbine side.

In a start-up stretch 62 (where the conversion device 13 is in a transitory connection state from the above-mentioned Stop state to the Run state) the voltage Uwt is ramped-up in order to reduce in-rush current of the transformers and the frequency fwt is set at its desired value. The desired rated values of Uwt and fwt at the end of this stretch may be different to the rated values of Ugrid and fgrid (for example fgrid=50 Hz and fwt =60 Hz). Then the voltage Uwt and the frequency fwt are kept at their rated values (within an admitted margin) in the stretch 63 (being then the conversion device 13 in the above mentioned Run connection state). Then the voltage Uwt and the frequency fwt are modified according to a pre-defined pattern in the test stretch 64. Then the voltage Uwt and the frequency fwt are kept at their rated values in the stretch 65 (being then the conversion device 13 in the above mentioned Run connection state). Finally in a shut-down stretch 66 the reverse operations to the start-up stretch are carried out.

Therefore the conversion device 13 is arranged for performing pre-defined tests in the test stretch 64 after the preparation stretches 62 and 63. Figure 8 shows an arrangement for performing a test that requires generating fluctuations of Uwt and fwt. If a test does not require such fluctuations Uwt and fwt are kept at their rated values (within an admitted margin).

The voltage and frequency at the wind turbine side can therefore be controlled following the references (mainly the RMS voltage and frequency) provided to the control means of the conversion device 13 according to the testing needs.

In particular in the above mentioned Run connection state the conversion device 13 generates at the wind turbine side a stable, balanced and controlled three phase voltage in a suitable bandwidth for the wind turbine 11.

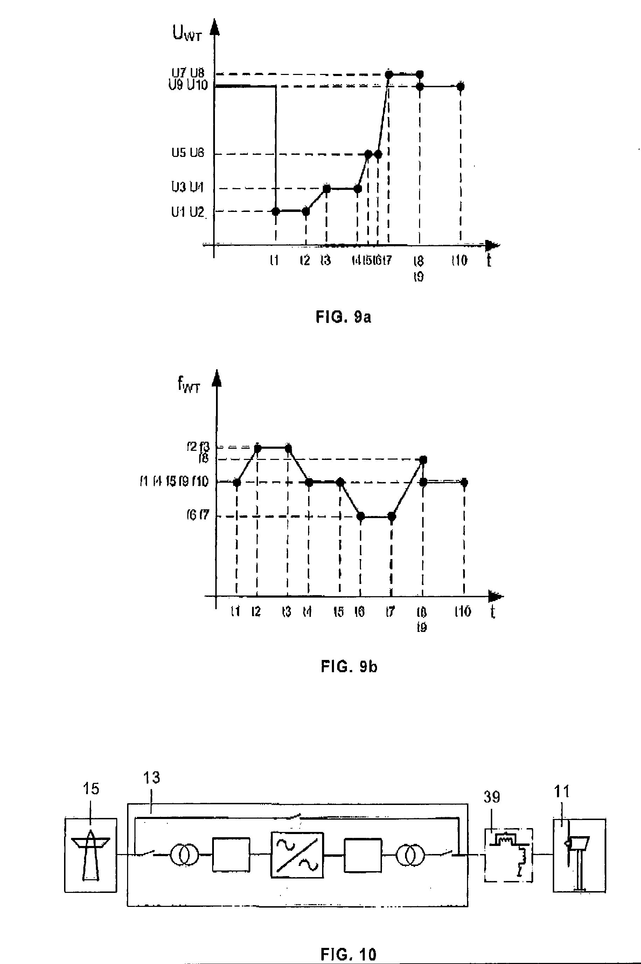

In certain tests the voltage Uwt and the frequency fwt shall follow a profile previously programmed in the control system of the conversion device 13. To program the voltage and frequency curves, ten pairs of points can be used for each reference as illustrated in Figures 9a and 9b.

From the point of view of the conversion device 13, the tests to be performed to the wind turbine 11 can be classified in steady state tests, quasi steady state tests and transient test.

The steady state tests are those tests that require that the values of the voltage and frequency at the wind turbine side of the conversion device 13 do not vary with time or suffer very attenuated dynamics irrespective of the variations of the power produced by the wind turbine 11 and the fluctuations of the power grid 15. In this test group are included those tests designed to validate the wind turbine performance in normal operating conditions and in production mode, with or without dynamic control of P/Q.

The quasi state tests are those tests that require that the voltage and frequency at the wind turbine side fluctuates in periods of minutes or even hours. These tests are typically electrical (involving generator, inverter, control cabinets and auxiliary and protection systems of the wind turbine) and are difficult to execute with direct connection to the power grid of the wind farm due to the impossibility of manipulating the grid parameters.

The transient tests are those tests involving a strong transient change on voltage and/or frequency at the wind turbine side such as in certain events in the following processes:
- Connection and disconnection processes.
- Disconnection processes due to internal faults that involve a sudden change in the conditions of production of up to 100% in P and Q.
- Change in operational processes by sudden changes in the network such as voltage dips.

The generation of said transient changes can be made using the conversion device 13 in combination with an external fault-generating equipment based on switched passive components such as a voltage dip generator 39 as illustrated in Figure 10. In that case the conversion device 13shall remain operableand keeping the desired voltage and frequency references when the voltage dip generator 39is in operation.

Among others, the method and the conversion device to perform tests to wind turbines according to the present invention have the following advantages:
- Allows testing prototypes of wind turbines having different rated frequencies with the same conversion device. Therefore two prototypes of the same wind turbine model for 50 and 60 Hz can be tested with the same conversion device facilitating the validation and certification of new models of wind turbines in a same site or in different sites.
- Allows testing wind turbines in field protecting the wind turbine against grid disturbances.
- Allows the testing of wind turbines in different sites irrespectively of the frequency of the power grid in each site.

Although the present invention has been described in connection with various embodiments, it will be appreciated from the specification that various combinations of elements, variations or improvements therein may be made, and are within the scope of the invention.

## Claims

1. A method for testing in field a wind turbine (11),
the wind turbine (11) being configured for providing power at a given rated voltage and at a rated frequency of 50 or 60 Hz;
the method comprising connecting the wind turbine (11) to an electric grid (15) of a given rated voltage and of a rated frequency of 50 or 60 Hz through a conversion device (13) that allows the adaptation of the features of the electric grid (15) at the wind turbine side of said conversion device (13) to the conditions requested by the tests to be performed to the wind turbine (11);
said adaptation including the adaptation of the rated frequency of the electric grid (15) to the rated frequency of the wind turbine (11), when they are different, so that identical tests to wind turbines (11) configured for different rated frequencies can be performed in the same site.

2. A method according to claim 1, wherein the rated voltages of the electric grid (15) and the wind turbine (11) are comprised between 10-66 kv.

3. A method according to any of claims 1-2, wherein said adaptation further comprises stabilizing the voltage and the frequency of the electric grid (15) at the wind turbine side of the conversion device (13).

4. A method according to any of claims 1-2, wherein said adaptation further comprises generating voltage and/or frequency fluctuations in predetermined time periods at the wind turbine side of the conversion device (13).

5. A method according to any of claims 1-2, wherein said adaptation further comprises generating voltage and/or frequency transients in predetermined time periods at the wind turbine side of the conversion device (13).

6. A method for testing in field a wind turbine (11),
the wind turbine (11) being configured for providing power at a given rated voltage and at a rated frequency of 50 or 60 Hz;
the method comprising connecting the wind turbine (11) to an electric grid (15) of a given rated voltage and of a rated frequency of 50 or 60 Hz through a conversion device (13) that allows the adaptation of the features of the electric grid (15) at the wind turbine side of said conversion device (13) to the conditions requested by the tests to be performed to the wind turbine (11), and througha voltage dip generator (39) at the wind side of said conversion device (13);
said adaptation including the adaptation of the rated frequency of the electric grid (15) to the rated frequency of the wind turbine (11), when they are different, so that identical tests to wind turbines (11) configured for different rated frequencies can be performed in the same site;
said voltage dip generator (39) allowing the generation of grid voltage transients in predetermined time periods at the wind turbine side of said conversion device (13).

7. A method according to claim 1, wherein the rated voltages of the electric grid (15) and the wind turbine (11) are comprised between 10-66 kv.

8. A method according to any of claims 7-8, wherein said adaptation further comprises stabilizing the voltage and the frequency of the electric grid (15) at the wind turbine side of the conversion device (13).

9. A method according to any of claims 7-8, wherein said adaptation further comprises generating voltage and/or frequency fluctuations in predetermined time periods at the wind turbine side of the conversion device (13).

10. A conversion device (13) connectable between one or more wind turbines (11) installed in a site and an electric grid (15) of a given rated voltage and of a rated frequency of 50 or 60 Hz for performing tests in field to the wind turbines (11);
said wind turbines (11) being configured for providing power at a given rated voltage and at a rated frequency of 50 or 60 Hz;
the conversion device (13) comprising one or more grid side transformers (21, 21', 21"), one or more converter units (23, 23', 23") and one or more wind turbine side transformers (25, 25', 25");
each converter unit (23, 23', 23") comprising a grid side harmonic filter (31, 31', 31") a back-to-back converter (33, 33', 33") and a wind turbine side harmonic filter (35, 35', 35");
the conversion device comprising control means allowing the adaptation of the features of the electric grid (15) at the wind turbine side of the conversion device (13) to the conditions requested by said tests;
said adaptation including the adaptation of the rated frequency of the electric grid (15) to the rated frequency of the wind turbine (11), when they are different, so that identical tests to wind turbines (11) configured for different rated frequencies can be performed in the same site.

11. A conversion device (13) according to claim 10, wherein said connection means comprise a wind turbine switchgear (16), a power grid switchgear (18) and a by-pass switch (20).

12. A conversion device (13) according to any of claims 10-11, wherein the conversion device (13) is configured in transportable modules.

13. A conversion device (13) according to claim 10-12, configured in three modules, the first module (44) comprising the grid side switchgear (16) and the grid side transformers (21, 21', 21"), the second module (46) comprising the converter units (23, 23', 23"), the third module (48) comprising the wind turbine side switchgear (18) and the wind turbine side transformers (25, 25', 25").

14. A conversion device (13) according to any of claims 10-13, wherein the rated voltages of the electric grid (15) and the wind turbine (11) are comprised between 10-66 kv.
